# EUROPÄISCHE PATENTSCHRIFT

(11) **EP 3 171 516 B1**
(45) Veröffentlichungstag und Bekanntmachung des Hinweises auf die Patenterteilung: **26.06.2019**
(21) Anmeldenummer: 15195304.9
(22) Anmeldetag: 19.11.2015
(51) Int. Cl.: H03K 17/14, H03K 17/689, H03K 17/16, H03K 5/156

(54) **SCHALTUNGSANORDNUNG MIT MINDESTENS EINEM LEISTUNGSTRANSISTOR FÜR EINEN UMRICHTER**
CIRCUIT ASSEMBLY WITH AT LEAST ONE POWER TRANSISTOR FOR A CONVERTER
CIRCUIT AVEC AU MOINS UN TRANSISTOR DE PUISSANCE POUR UN CONVERTISSEUR

(43) Veröffentlichungstag der Anmeldung: 24.05.2017
(73) Patentinhaber: ETEL S.A., 2112 Môtiers (CH)
(72) Erfinder: MAUERER, Mario, 8006 Zürich (CH); KOLAR, Johann W., 8044 Zürich (CH)
(74) Vertreter: Pleyer, Hans Anno

(56) Entgegenhaltungen:
- DE-U1-202004 012 961
- GB-A- 2 373 654
- US-A1- 2009 309 643
- US-B2- 8 742 841

## Beschreibung

### GEBIET DER TECHNIK

Die vorliegende Erfindung betrifft eine Schaltungsanordnung mit mindestens einem Leistungstransistor für einen Umrichter. Solche Leistungstransistoren sind häufig in einer Halbbrückenschaltung zwischen ein oberes und ein unteres Potential geschaltet, so dass ein gemeinsamer Anschluss von zwei Transistoren durch ein abwechselndes Ein- und Ausschalten der Transistoren zwischen diesen beiden Potentialen umgeschaltet werden kann. Im zeitlichen Mittel kann auf diese Weise ein beliebiges Potential zwischen dem oberen und dem unteren Potential eingestellt werden.

Solche Umrichter kommen z.B. bei der Ansteuerung von Positioniereinrichtungen zum Einsatz, wenn deren elektrischen Antriebe so angesteuert werden sollen, dass der Antrieb eine bestimmte Stellung einnimmt. Dabei werden die Leistungstransistoren beispielsweise mittels der bekannten Pulsweitenmodulation (PWM) angesteuert. Die zur Ansteuerung der Leistungstransistoren generierten digitalen PWM-Signale müssen aus Sicherheitsgründen von der zum Betrieb der elektrischen Antriebe verwendeten Hochspannung galvanisch getrennt werden. Hierzu dienen häufig Optokoppler, die ein Signal mittels Licht übertragen können. Diese Optokoppler haben den Vorteil, dass sie unabhängig von der Frequenz eines Signales eingesetzt werden können, während nach dem Transformatorprinzip arbeitende Übertrager eine gewisse Mindestfrequenz voraussetzen. Der Einsatz von Optokopplern führt allerdings dazu, dass digitale Schaltsignale zeitlich verzögert übertragen werden, wobei diese Verzögerung zudem nicht konstant ist, sondern kleinen Schwankungen unterliegt. Man spricht bei diesen Schwankungen von einem Jitter, der für eine zeitliche Variation oder Unsicherheit der Flanken in den übertragenen digitalen Signalen sorgt.

Dieser Jitter bewirkt bei der Ansteuerung von Positioniereinrichtungen ein breitbandiges Rauschen in der Ansteuerung und damit letztlich in der Bewegung der Antriebe, und verschlechtert so die Positioniergenauigkeit. Die Schaltvorgänge in den Halbbrücken eines Umrichters treten nicht exakt zu den eigentlich vorgesehenen Zeitpunkten auf, sondern weichen zeitlich in zufälliger Weise davon ab.

### STAND DER TECHNIK

Aus der DE 202004012961 U1 ist eine Schaltungsanordnung bekannt, mit der mehrere Module über serielle Schnittstellen an eine übergeordnete Steuerung angebunden werden können. Die Übertragung der Daten von einem Modul zur Steuerung, der Daten von der Steuerung zu einem Modul und eines Taktsignals erfolgt dabei über drei separate Kommunikationsverbindungsisolatoren. Da auch die Energieversorgung der Module über Trenntransformatoren erfolgt, sind die Module galvanisch von der übergeordneten Steuerung getrennt.

Im Bereich der digitalen Audio - Verstärker führt Jitter bei der Ansteuerung der Leistungshalbleiter zu verfälschten Signalen bei der Ansteuerung von Lautsprechern. Aus der US 8742841 B2 ist es bereits bekannt, zur Verminderung des Jitters in Audiosignalen eine getrennte Übertragung eines digitalen Audio-Signals und eines Takt-Signals vorzunehmen, und nach einer Potentialverschiebung der beiden Signale eine erneute Synchronisierung des Audiosignals vorzunehmen. Details zur Potentialverschiebung sind aber nicht offenbart, und wären wohl auch nicht übertragbar auf die völlig anderen Sicherheitsanforderungen im Bereich der Umrichter - Technologie in Positioniereinrichtungen, bei der mit einer Spannung im Bereich von mehreren hundert Volt gearbeitet wird, die mit hohen Frequenzen geschaltet werden muss.

### ZUSAMMENFASSUNG DER ERFINDUNG

Es ist daher Aufgabe der Erfindung, eine Schaltungsanordnung zur Ansteuerung von Leistungstransistoren eines Umrichters anzugeben, mit der die Potentialtrennung zwischen dem Signalprozessor zur Erzeugung von PWM-Signalen und den Leistungstransistoren bewerkstelligt werden kann, ohne dabei ein zu hohes Maß an Jitter bei der Ansteuerung der Transistoren zu verursachen.

Diese Aufgabe wird gelöst durch eine Vorrichtung gemäß Anspruch 1. Vorteilhafte Details dieser Vorrichtung ergeben sich auch aus den von Anspruch 1 abhängigen Ansprüchen.

Es wird eine Schaltungsanordnung zur Ansteuerung von Leistungstransistoren eines Umrichters offenbart, mit einer Logikschaltung zur Erzeugung eines PWM-Signals und einem Taktgeber zur Erzeugung eines Taktsignals, sowie mit einem ersten bzw. zweiten Isolator zur galvanisch isolierten Übertragung des PWM-Signals bzw. des Taktsignals in einen Hochspannungsbereich des Umrichters, wobei ein galvanisch isoliertes PWM-Signal und ein galvanisch isoliertes Taktsignal entsteht. Die Schaltungsanordnung weist außerdem eine Korrekturschaltung auf, die einen Jitter des galvanisch isolierten PWM-Signals anhand des galvanisch isolierten Taktsignals korrigiert, dadurch gekennzeichnet, dass der erste Isolator für das PWM-Signal so ausgeführt ist, dass er sowohl Gleichspannungssignale also auch Wechselspannungssignale übertragen kann, und dass der zweite Isolator zur galvanisch isolierten Übertragung einen um wenigstens den Faktor zwei, bevorzugt den Faktor fünf, besonders bevorzugt den Faktor zehn niedrigeren Jitter aufweist als der erste Isolator.

Der erste Isolator ist erfindungsgemäß als Optokoppler oder als digitaler Signalisolator ausgeführt, und muss auch Signale mit sehr niedrigen Frequenzen (also auch Gleichspannungs- bzw. DC-Signale) übertragen können. Solche Bausteine sind kommerziell erhältlich, haben allerdings den Nachteil, dass sie dem übertragenen Signal in erheblichem Umfang Jitter hinzufügen. Dies bedeutet, dass die Flanken des übertragenen Signals zeitlich nicht mehr besonders gut mit dem originalen Signal korrelieren, oder dass das übertragene Signal verrauscht ist.

Der zweite Isolator ist erfindungsgemäß als Hochfrequenzübertrager z.B. basierend auf LVDS - Bausteinen ausgeführt. Das Taktsignal wird mittels eines LVDS-Treibers auf die Primärseite eines Hochfrequenztransformators geschaltet. Sekundärseitig wird der Hochfrequenztransformator mit einem LVDS-Empfänger verbunden, der dann das galvanisch isolierte Taktsignal abgibt. So eine Anordnung kann hochfrequente Taktsignale mit Frequenzen bis über 200 MHz galvanisch isoliert übertragen. Dabei wird dem Taktsignal nur ein sehr geringes Maß an Jitter hinzugefügt, typischerweise im Bereich einiger Pikosekunden. Dies bedeutet, dass die Flanken des galvanisch isolierten Taktsignals zeitlich sehr gut mit den Flanken des ursprünglichen Taktsignals korrelieren. Anders ausgedrückt wird nur sehr wenig Rauschen zum Taktsignal hinzugefügt.

Mit der Korrekturschaltung ist es möglich, das galvanisch isolierte PWM-Signal mit dem galvanisch isolierten Taktsignal zu synchronisieren, etwa indem das korrigierte PWM-Signal sich nur bei einer steigenden Flanke des galvanisch isolierten Taktsignals ändert.

Das von der Korrekturschaltung ausgegebene korrigierte PWM-Signal ist nun wieder mit dem Taktsignal synchronisiert, so dass die Leistungstransistoren genau zu den vorgesehenen Zeitpunkten schalten. Das Rauschen in der Ansteuerung der Transistoren ist somit deutlich reduziert, die Positioniergenauigkeit einer Positioniereinrichtung erheblich verbessert. In Versuchen konnte mit der Korrekturschalung der Jitter bei der Ansteuerung der Leistungstransistoren um einen Faktor zehn reduziert werden.

Da im Bereich der Umrichter hohe Spannungen geschaltet werden, drohen außerdem Störsignale von den Isolatoren (auch als "common mode transients" bezeichnet). Die Korrekturschaltung ist daher als taktflankengesteuertes D-Flip-Flop mit einem Clock-Enable-Eingang ausgebildet. An diesem Clock-Enable-Eingang kann ein Sperrsignal zu den Zeitpunkten angelegt werden, zu denen solche Störsignale möglicherweise auftreten, also in dem Moment, in dem ein Leistungstransistor umschaltet. Damit wird verhindert, dass einer der Leistungstransistoren unerwünscht schaltet - denn solche Schaltvorgänge können sogar zu einem Kurzschluss führen, wenn dadurch gleichzeitig beide Leistungstransistoren einer Halbbrücke leitend werden. Durch diese Maßnahme erreicht man also insgesamt eine isolierte Übertragung der PWM-Signale mit sehr niedrigem Jitter, und vermeidet gleichzeitig Probleme mit Störsignalen, die an Isolatoren typischerweise auftreten, wenn hohe Spannungen schnell geschaltet werden müssen. Somit ist eine besonders genaue, rauscharme Ansteuerung von elektrischen Antrieben möglich.

### KURZE BESCHREIBUNG DER ZEICHNUNGEN

Dabei zeigt
- Figur 1: eine erfindungsgemäße Schaltungsanordnung,
- Figur 2: ein Signaldiagramm.

### BESCHREIBUNG DER AUSFÜHRUNGSFORMEN

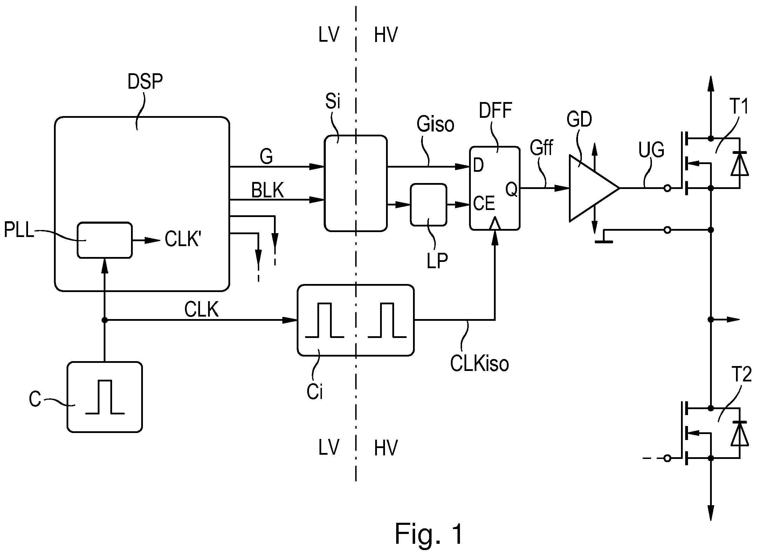

Die Figur 1 zeigt eine erfindungsgemäße Schaltungsanordnung. Eine Logikschaltung DSP wird von einem Taktgeber C mit einem möglichst genauen Takt CLK versorgt. Die Logikschaltung DSP dient dazu, PWM-Signale G zu erzeugen, die letztlich der pulsweitenmodulierten Ansteuerung eines Antriebs dienen. Außerdem wird von der Logikschaltung ein Sperrsignal BLK erzeugt. Intern verwendet die Logikschaltung einen zum Takt CLK zeitlich verschobenen Takt CLK', der beispielsweise mit einer PLL-Schaltung aus dem Takt CLK generiert wird. Die Logikschaltung kann beispielsweise als DSP oder FPGA ausgebildet sein.

Die Logikschaltung DSP ist in einem Niederspannungsbereich LV angeordnet. Da letztlich eine Betriebsspannung von mehreren hundert Volt geschaltet werden soll, müssen die Signale G, BLK und CLK über Isolatoren Si, Ci in den Hochspannungsbereich HV übertragen werden, wo sie als galvanisch isolierte Signale Giso, CLKiso und BLKiso weiter verarbeitet werden.

Der erste Isolator Si ist erfindungsgemäß als Optokoppler ausgebildet. Diese haben den Vorteil, dass sie Signale unabhängig von der Frequenz übertragen können (insbesondere auch konstante DC-Signale), während sie jedoch ein erhebliches Maß an Jitter in den Signalflanken verursachen können. Würde man ein derart übertragenes PWM-Signal unmittelbar zur Ansteuerung der Gate-Treiber GD der Leistungstransistoren T1, T2 verwenden, so würden diese mit einem deutlich verrauschten Signal angesteuert. Die Flanken der Gate-Spannung UG würden eine von der Vorgabe der Logikschaltung DSP abweichende, nicht konstante zeitliche Lage aufweisen - eben den vor allem durch den Isolator Si verursachten Jitter.

Der zweite Isolator Ci für das Taktsignal CLK ist daher als digitaler Hochfrequenzübertrager mit besonders niedrigem Jitter ausgeführt. Solche Isolatoren basieren beispielsweise auf einer kapazitiven oder induktiven Übertragung der Signale und sind gängige Bausteine der Datenübertragung. Der Jitter dieses zweiten Isolators Ci sollte wenigstens um einen Faktor zwei, besser um einen Faktor zehn oder zwanzig kleiner sein als der vom ersten Isolator Si, da der darüber übertragene Takt CLKiso als Referenz für die Resynchronisierung des PWM-Signals Giso dient. Nur dann kann der Jitter in der Ansteuerung der Leistungstransistoren T1, T2 erfolgreich unterdrückt werden. Da das Taktsignal CLK ein Signal mit konstant hoher Frequenz (z.B. 100 MHz) ist, wird hier erfindungsgemäß ein Hochfrequenzübertrager verwendet, welcher eben nur für hochfrequente Signale geeignet ist, dafür aber einen besonders geringen Jitter verursacht.

Mit Hilfe einer Korrekturschaltung DFF wird nun das mit einem großen Jitter behaftete Signal Giso auf den mit nur geringem Jitter behafteten Takt CLKiso synchronisiert. Dies wird mittels einer Flip-Flop-Schaltung bewerkstelligt. Das so erhaltene, also Jitter kompensierte PWM-Signal Gff folgt dem Signal Giso immer dann, wenn der Takt CLKiso eine steigende Flanke aufweist. Damit wird wieder eine zeitliche Korrelation zwischen den Flanken des PWM-Signals Gff erreicht, wie sie ursprünglich von der Logikschaltung DSP vorgegeben wurde. Das Signal Gff steuert dann einen Gate-Treiber GD an, der schließlich die Gate-Spannung UG an den Leistungstransistor T1, T2 ausgibt.

In der Figur 1 ist nur die Ansteuerschaltung für den ersten Transistor T1 gezeigt, der zweite Transistor T2 wird aber ganz genauso angesteuert, schon um für alle Signale die gleichen Laufzeiten zu erhalten.

Wenn der Leistungstransistor T1 schaltet, ergibt sich am ersten Isolator Si eine sehr schnelle Spannungsänderung. Diese kann zu einem Störsignal auf der Signalleitung von Giso und damit zu einem unerwünschten Schaltvorgang am Transistor T1 führen. So ein Schaltvorgang kann zur Zerstörung des Umrichters führen, wenn dadurch beide Transistoren T1, T2 gleichzeitig leitend werden.

Die Schaltungsanordnung weist daher ein weiteres vorteilhaftes Merkmal auf. Die Korrekturschaltung DFF ist als taktflankengesteuertes D-Flip-Flop mit einem Clock-Enable-Eingang CE ausgebildet. Solange an diesem Eingang CE ein Sperrsignal BLKiso als logische 1 (high) anliegt, arbeitet das Flip-Flop wie vorgesehen, es synchronisiert das Signal Giso mit der nächsten steigenden Flanke von CLKiso und gibt das resultierende, Jitter kompensierte Signal Gff aus. Liegt als Sperrsignal BLKiso aber eine logische 0 (low) an, so wird die Synchronisierung unterbrochen. Zustandsänderungen am Eingang D des Flip-Flops werden dann nicht mehr an den Ausgang Q weitergegeben.

In der Logikschaltung DSP wird daher zusätzlich ein Sperrsignal BLK erzeugt, das normalerweise eine logische 1 darstellt, aber mit einer gewissen Verzögerung nach jeder Zustandsänderung im PWM-Signal G für eine gewisse Zeit auf eine logische Null wechselt. Die Verzögerung ist dabei so gewählt, dass der der Zustandsänderung in G zugeordnete Schaltvorgang im Signal Gff bereits stattgefunden hat, aber die Verzögerunszeit Tpdgd des Gate-Treibers GD noch nicht abgelaufen ist. Der Transistor T1 hat also noch nicht geschaltet. Dann nimmt also die Korrekturschaltung DFF keine Änderungen auf der Signalleitung Giso mehr an. Störsignale, die beim Schalten des Transistors T1 auftreten können, werden ignoriert. Nach einer gewissen Zeit, wenn solche Störsignale nicht mehr auftreten können, gibt das Sperrsignal BLKiso die Korrekturschaltung DFF wieder frei. Das Sperrsignal BLK wird wie das PWM-Signal G über einen zweiten Kanal des ersten Isolators Si (oder einen Baugleichen Isolator) übertragen und damit zum galvanisch getrennten Sperrsignal BLKiso. Somit sind für G und BLK vergleichbare Laufzeiten gewährleistet.

Das Sperrsignal BLKiso wird außerdem über ein Tiefpassfilter LP geführt, um auch dort kurze Störsignale zu unterdrücken. Damit die Absenkung auf die logische 0 dennoch schnell erfolgt, ist der Tiefpassfilter LP von einer Diode überbrückt. So ein Tiefpassfilter könnte zwar auch Störsignale in Giso filtern, würde aber zu einer Verschlechterung des PWM-Signals beitragen.

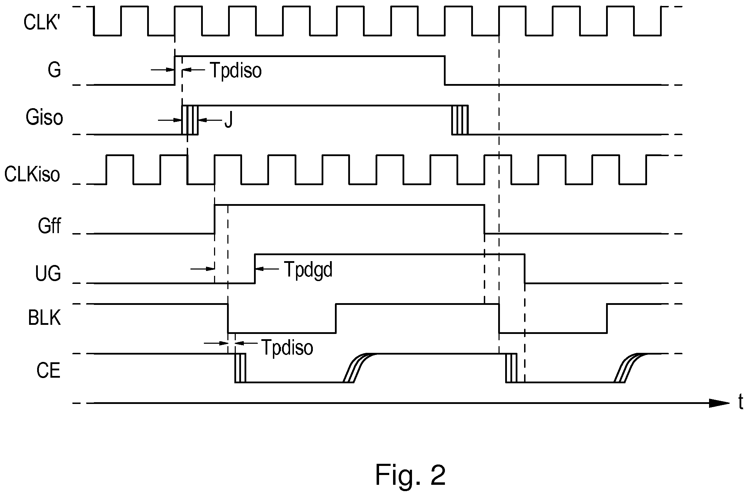

In der Figur 2 sind die einzelnen Signale in einer beispielhaften zeitlichen Abfolge dargestellt.

In der Logikschaltung DSP wird wie erwähnt ein zum eigentlichen Takt CLK zeitlich versetztes Taktsignal CLK' erzeugt. Mit diesem Versatz ist es möglich, die bei der Verarbeitung aller Signale auftretenden Verzögerungen zu berücksichtigen, und letztlich einen Offset zwischen der Verarbeitung auf der Niederspannungsseite LV und auf der Hochspannungsseite HV passend einzustellen. Insbesondere muss der Versatz zwischen CLK und CLK' die setup/hold Zeiten der Korrekturschaltung DFF berücksichtigen.

Man erkennt außerdem das von der Logikschaltung DSP generierte PWM-Signal G, mit dem der Transistor T1 für eine gewisse Zeitspanne eingeschaltet werden soll. Das PWM-Signal G schaltet mit steigenden Flanken von CLK'. Nach der galvanisch isolierten Übertragung liegt das Signal Giso vor, dessen Flanken wie angedeutet einem gewissen Jitter J unterliegen. Durch die mehrfach eingezeichneten Flanken ist angedeutet, dass diese Flanken nicht nur einer gewissen Verzögerung Tpdiso unterliegen, sondern dass diese Verzögerung auch nicht konstant ist, wodurch das ursprüngliche Signal G verrauscht wird. Der Jitter J wird vor allem durch den Isolator Si verursacht, aber auch andere Schaltelemente im Signalpfad oder elektromagnetische Interferenzen tragen zum Jitter J bei.

Demgegenüber ist das galvanisch isolierte Taktsignal CLKiso nicht oder jedenfalls deutlich weniger von Jitter betroffen. Ein zweiter Isolator Ci mit möglichst geringem Jitter ist hierfür eine notwendige Voraussetzung.

Man erkennt außerdem, dass die Korrekturschaltung DFF (also die Flip-Flop-Schaltung) dafür sorgt, dass im korrigierten PWM-Signal Gff jede Flanke im Signal Giso erst mit der nächsten steigenden Flanke von CLKiso übernommen wird. Auf diese Weise wird das PWM-Signal wieder auf den Takt CLKiso synchronisiert. Der Versatz zwischen CLK und CLK' muss so gewählt sein, dass unter Berücksichtigung der Laufzeit Tpdiso und des maximalen Jitters J die nächste steigende Flanke von CLKiso eine Flanke von Giso auf den Ausgang Q der Korrekturschaltung DFF schalten kann. Das bedeutet, dass Giso etwa im Bereich einer fallenden Flanke von CLKiso schalten sollte.

Das Signal Gff am Ausgang Q der Korrekturschaltung DFF steuert den Gate-Treiber GD an, so dass mit einer Verzögerungszeit Tpdgd das Gate des Transistors T1 mit der Spannung UG angesteuert wird.

In der Figur 2 ist außerdem noch dargestellt, wie der zeitliche Verlauf des Sperrsignals BLK gewählt ist. Das normalerweise auf einer logischen 1 (bzw. auf high) stehende Sperrsignal BLK schaltet nach jeder Zustandsänderung von Gff, aber noch innerhalb der Verzögerungszeit Tpdgd des Gate-Treibers auf 0 (bzw. auf low). Dabei ist auch die Verzögerungszeit Tpdiso des ersten Isolators Si zu berücksichtigen, die ja auch auf das Sperrsignal BLK wirkt. Wegen der Diode über dem Tiefpassfilter LP fällt dann der Eingang schnell auf low. Der Schaltvorgang am Transistor T1 wird zwar durchgeführt, daraus resultierende Störsignale auf Giso werden aber unterdrückt. Nach einer gewissen Zeit (wenn keine Störsignale mehr auftreten können, weil die Umschaltung am Transistor T1 abgeschlossen ist) geht dann BLK wieder auf high, und der Clock-Enable-Eingang CE der Korrekturschaltung DFF folgt wegen des Tiefpassfilters LP langsam ansteigend. Die Korrekturschaltung DFF ist damit bereit für den nächsten Schaltvorgang in Giso.

Die Schaltungsanordnung ermöglicht also eine Ansteuerung der Transistoren T1, T2 mit sehr geringem Jitter und damit eine genaue Positionierung der Antriebe, und verhindert gleichzeitig Probleme mit Störsignalen, die während einzelnen Schaltvorgängen an den Isolatoren auftreten können.

## Patentansprüche

1. Schaltungsanordnung mit mindestens einem Leistungstransistor (T1, T2) für einen Umrichter, mit einer Logikschaltung (DSP) zur Erzeugung eines PWM-Signals (G), das der Ansteuerung des mindestens einen Leistungstransistors (T1, T2) dient, und mit einem Taktgeber (C) zur Erzeugung eines Taktsignals (CLK), sowie mit einem ersten Isolator (Si) ausgestaltet zur galvanisch isolierten Übertragung des PWM-Signals (G) und mit einem zweiten Isolator (Ci) ausgestaltet zur galvanisch isolierten Übertragung des Taktsignals (CLK) in einen Hochspannungsbereich (HV) des Umrichters, wobei ein galvanisch isoliertes PWM-Signal (Giso) und ein galvanisch isoliertes Taktsignal (CLKiso) entsteht, sowie mit einer Korrekturschaltung (DFF), die einen Jitter des galvanisch isolierten PWM-Signals (Giso) anhand des galvanisch isolierten Taktsignals (CLKiso) korrigiert, wobei der erste Isolator (Si) für das PWM-Signal (G) als Optokoppler oder als digitaler Signalisolator ausgeführt ist, der sowohl Gleichspannungssignale als auch Wechselspannungssignale übertragen kann, und dass der zweite Isolator (Ci) als Hochfrequenzübertrager basierend auf einem Hochfrequenztransformator ausgeführt ist, wobei der zweite Isolator (Ci) derart ausgestaltet ist, dass er bei der galvanisch isolierten Übertragung des Taktsignals (CLK) einen um wenigstens den Faktor zwei, bevorzugt den Faktor zehn, besonders bevorzugt den Faktor zwanzig niedrigeren Jitter (J) verursacht als der erste Isolator (Si) bei der Übertragung des PWM-Signals (PWM).

2. Schaltungsanordnung nach Anspruch 1, **dadurch gekennzeichnet, dass** die Korrekturschaltung (DFF) als Flip-Flop-Schaltung ausgebildet ist.

3. Schaltungsanordnung nach Anspruch 2, **dadurch gekennzeichnet, dass** die Korrekturschaltung (DFF) als D-Flip-Flop-Schaltung ausgebildet ist, an dessen Eingang (D) das galvanisch isolierte PWM-Signal (Giso) anliegt, an dessen Takteingang (C) das galvanisch isolierte Taktsignal (CLKiso) anliegt, und dessen Ausgang (Q) somit einem veränderten galvanisch isolierten PWM-Signal (Giso) erst mit der nächsten steigenden Flanke des galvanisch isolierten Taktsignals (CLKiso) folgt, wodurch ein PWM-Signal (Gff) mit reduziertem Jitter (J) gebildet ist.

4. Schaltungsanordnung nach Anspruch 2 oder 3, **dadurch gekennzeichnet, dass** die Korrekturschaltung (DFF) als taktflankengesteuertes D-Flip-Flop mit einem Clock-Enable-Eingang (CE) ausgebildet ist.

5. Schaltungsanordnung nach Anspruch 4, **dadurch gekennzeichnet, dass** am Clock-Enable-Eingang (CE) der Korrekturschaltung (DFF) ein galvanisch isoliertes Sperrsignal (BLKiso) anliegt, das eine Änderung des korrigierten PWM-Signals (Gff) während einer Umschaltung des mindestens einen Leistungstransistors (T1, T2) verhindert.

6. Schaltungsanordnung nach Anspruch 5, **dadurch gekennzeichnet, dass** von der Logikschaltung (DSP) ein Sperrsignal (BLK) zeitlich verzögert zu einer Änderung des PWM-Signals (G) erzeugbar ist, das wie das PWM-Signal (G) über den ersten Isolator (Si) übertragen ist, und als galvanisch isoliertes Blockierungssignal (BLKiso) dem Clock-Enable-Eingang (CE) der Korrekturschaltung (DFF) zugeführt ist.

7. Schaltungsanordnung nach Anspruch 5 oder 6, **dadurch gekennzeichnet, dass** das galvanisch isolierte Blockierungssignal (BLKiso) über ein Tiefpassfilter (LP) dem Clock-Enable-Eingang (CE) der Korrekturschaltung (DFF) zugeführt ist.

8. Schaltungsanordnung nach Anspruch 7, **dadurch gekennzeichnet, dass** der Tiefpassfilter (LP) mit einer Diode (D) überbrückt ist.

9. Schaltungsanordnung nach einem der vorhergehenden Ansprüche, **dadurch gekennzeichnet, dass** das von der Korrekturschaltung (DFF) erzeugte korrigierte PWM-Signal (Gff) zur Ansteuerung eines Gate-Treibers (GD) für den mindestens einen Leistungstransistor (T1, T2) dient.

## Claims

1. Circuit arrangement with at least one power transistor (T1, T2) for a converter, with a logic circuit (DSP) for generating a PWM signal (G) that is used for the control of the at least one power transistor (T1, T2), and with a clock generator (C) for the generation of a clock signal (CLK), as well as with a first isolator (Si) designed for the galvanically isolated transmission of the PWM signal (G) and with a second isolator (Ci) designed for the galvanically isolated transmission of the clock signal (CLK) into a high-voltage region (HV) of the converter, wherein a galvanically isolated PWM signal (Giso) and a galvanically isolated clock signal (CLKiso) occur, and with a correction circuit (DFF) that corrects a jitter of the galvanically isolated PWM signal (Giso) on the basis of the galvanically isolated clock signal (CLKiso), wherein the first isolator (Si) for the PWM signal (G) is implemented as an optocoupler or as a digital signal isolator which can transmit both direct voltage signals as well as alternating voltage signals, and that the second isolator (Ci) is implemented as a high-frequency transducer based on a high-frequency transformer, wherein the second isolator (Ci) is designed such that in the galvanically isolated transmission of the clock signal (CLK) it causes a jitter (J) that is lower than the first isolator (Si) in the transmission of the PWM signal (PWM) by at least the factor two, preferably the factor ten, particularly preferably the factor twenty.

2. Circuit arrangement according to Claim 1, **characterized in that** the correction circuit (DFF) is formed as a flip-flop circuit.

3. Circuit arrangement according to Claim 2, **characterized in that** the correction circuit (DFF) is formed as a D-flip-flop circuit, at whose input (D) the galvanically isolated PWM signal (Giso) is present, at whose clock input (C) the galvanically isolated clock signal (CLKiso) is present, and whose output (Q) thus only follows a changed, galvanically isolated PWM signal (Giso) at the next rising edge of the galvanically isolated clock signal (CLKiso), whereby a PWM signal (Gff) with reduced jitter (J) is formed.

4. Circuit arrangement according to Claim 2 or 3, **characterized in that** the correction circuit (DFF) is formed as a clock-edge controlled D-flip-flop with a clock-enable input (CE).

5. Circuit arrangement according to Claim 4, **characterized in that** a galvanically isolated blocking signal (BLKiso) is present at the clock-enable input (CE) of the correction circuit (DFF), and said blocking signal prevents a change in the corrected PWM signal (Gff) during a switchover of the at least one power transistor (T1, T2).

6. Circuit arrangement according to Claim 5, **characterized in that** a blocking signal (BLK) can be generated by the logic circuit (DSP) delayed in time with respect to a change in the PWM signal (G), which, like the PWM signal (G), is transmitted by the first isolator (Si), and is supplied as a galvanically isolated blocking signal (BLKiso) to the clock-enable input (CE) of the correction circuit (DFF).

7. Circuit arrangement according to Claim 5 or 6, **characterized in that** the galvanically isolated blocking signal (BLKiso) is passed to the clock-enable input (CE) of the correction circuit (DFF) via a low-pass filter (LP).

8. Circuit arrangement according to Claim 7, **characterized in that** the low-pass filter (LP) is bridged by a diode (D).

9. Circuit arrangement according to one of the preceding claims, **characterized in that** the corrected PWM signal (Gff) generated by the correction circuit (DFF) is used for control of a gate driver (GD) for the at least one power transistor (T1, T2).

## Revendications

1. Arrangement de circuit comprenant au moins un transistor de puissance (T1, T2) pour un convertisseur statique, comprenant un circuit logique (DSP) destiné à générer un signal PWM (G) qui sert à l'excitation de l'au moins un transistor de puissance (T1, T2), et comprenant un générateur d'horloge (C) destiné à générer un signal d'horloge (CLK), et comprenant aussi un premier isolateur (Si) configuré pour la transmission avec isolation galvanique du signal PWM (G) et un deuxième isolateur (Ci) configuré pour la transmission avec isolation galvanique du signal d'horloge (CLK) dans une plage de haute tension (HV) du convertisseur statique, un signal PWM isolé galvaniquement (Giso) et un signal d'horloge isolé galvaniquement (CLKiso) étant produits, et comprenant aussi un circuit de correction (DFF) qui corrige une gigue du signal PWM isolé galvaniquement (Giso) à l'aide du signal d'horloge isolé galvaniquement (CLKiso), le premier isolateur (Si) pour le signal PWM (G) étant réalisé sous la forme d'un optocoupleur ou d'un isolateur de signal numérique qui peut transmettre aussi bien des signaux en tension continue que des signaux en tension alternative, et que le deuxième isolateur (Ci) est réalisé sous la forme d'un transmetteur à haute fréquence sur la base d'un transformateur à haute fréquence, le premier isolateur (Ci) étant configuré de telle sorte que lors de la transmission avec isolation galvanique du signal d'horloge (CLK), il cause une gigue (J) plus faible au moins d'un facteur deux, de préférence d'un facteur dix, notamment de préférence d'un facteur vingt par rapport au premier isolateur (Si) lors de la transmission du signal PWM (PWM).

2. Arrangement de circuit selon la revendication 1, **caractérisé en ce que** le circuit de correction (DFF) est réalisé sous la forme d'un circuit Flip-Flop.

3. Arrangement de circuit selon la revendication 2, **caractérisé en ce que** le circuit de correction (DFF) est réalisé sous la forme d'un circuit Flip-Flop D à l'entrée (D) duquel est appliqué le signal PWM isolé galvaniquement (Giso), à l'entrée d'horloge (C) duquel est appliqué le signal d'horloge isolé galvaniquement (CLKiso) et dont la sortie (Q) suit ainsi un signal PWM isolé galvaniquement (Giso) modifié seulement avec le prochain front montant du signal d'horloge isolé galvaniquement (CLKiso), ce qui forme un signal PWM (Gff) ayant une gigue (J) réduite.

4. Arrangement de circuit selon la revendication 2 ou 3, **caractérisé en ce que** le circuit de correction (DFF) est réalisé sous la forme d'un circuit Flip-Flop D commandé par front d'horloge pourvu d'une entrée d'activation d'horloge (CE).

5. Arrangement de circuit selon la revendication 4, **caractérisé en ce qu'**un signal de blocage isolé galvaniquement (BLKiso) est appliqué à l'entrée d'activation d'horloge (CE) du circuit de correction (DFF), lequel empêche une modification du signal PWM corrigé (Gff) pendant une permutation de l'au moins un transistor de puissance (T1, T2).

6. Arrangement de circuit selon la revendication 5, **caractérisé en ce que** le circuit logique (DSP) peut générer un signal de blocage (BLK) retardé dans le temps pour une modification du signal PWM (G), lequel est transmis par le biais du premier isolateur (Si) comme le signal PWM (G) et est acheminé en tant que signal de blocage isolé galvaniquement (BLKiso) à l'entrée d'activation d'horloge (CE) du circuit de correction (DFF).

7. Arrangement de circuit selon la revendication 5 ou 6, **caractérisé en ce que** le signal de blocage isolé galvaniquement (BLKiso) est acheminé à l'entrée d'activation d'horloge (CE) du circuit de correction (DFF) par le biais d'un filtre passe-bas (LP).

8. Arrangement de circuit selon la revendication 7, **caractérisé en ce que** le filtre passe-bas (LP) est ponté par une diode (D).

9. Arrangement de circuit selon l'une des revendications précédentes, **caractérisé en ce que** le signal PWM corrigé (Gff) généré par le circuit de correction (DFF) sert au pilotage d'un circuit d'attaque de gâchette (GD) pour l'au moins un transistor de puissance (T1, T2).
